# EUROPEAN PATENT APPLICATION

(11) **EP 3 483 627 A1**
(43) Date of publication of application: **15.05.2019**
(21) Application number: 18194551.0
(22) Date of filing: 14.09.2018
(51) Int. Cl.: G01S 7/486, G01S 17/02, G01S 17/89, G01S 17/10

(54) **OPTICAL SENSOR AND DETECTION METHOD**

(30) Priority: 31.10.2017 JP 2017210034
(71) Applicant: OMRON CORPORATION, Kyoto-shi, Kyoto 600-8530 (JP)
(72) Inventor: Ando, Shintaro, Kyoto-shi, Kyoto 600-8530 (JP); Iida, Yusuke, Kyoto-shi, Kyoto 600-8530 (JP); Shimizu, Tetsu, Kyoto-shi, Kyoto 600-8530 (JP)
(74) Representative: Ter Meer Steinmeister & Partner

(57) **Abstract**

Provided are an optical sensor and a detection method which can suppress an influence of an ambient light to detect a target. An optical sensor (100) which detect a target (TA) includes: a light reception portion (20), in which multiple pixels respectively receive lights and a light reception distribution signal showing a light reception amount of each pixel is obtained; an A/D conversion portion (30), which converts the light reception distribution signal to a digital signal for each pixel; an integration portion (55), which integrates multiple converted light reception distribution signals for each pixel; and a determination portion (58), which determines the presence or absence of the target (TA) based on the integrated light reception distribution signal.

## Description

### BACKGROUND OF THE INVENTION

### Technical Field

The present invention relates to an optical sensor and a detection method.

### Related Art

Conventionally, it is known that in an optical sensor, which receives a reflected light from a target and detects an object based on the light reception state, a maximum peak is detected from light reception amount distribution data generated from an imaging element through an A/D conversion circuit, and a sensitivity adjustment process is carried out by using the maximum peak (see patent literature 1). Here, if an exposure time of the imaging element is long, a signal input to the A/D conversion circuit exceeds an upper limit of an input signal range of the A/D conversion circuit, and a light reception amount of the light reception amount distribution data is saturated. If the light reception amount is saturated, there is a risk that the maximum peak cannot be accurately detected. Therefore, in a sensitivity adjustment process in patent literature 1, when the light reception amount of the maximum peak of the light reception amount distribution data is saturated, the exposure time is reduced.

[Patent literature 1] Japanese Laid-open No. 2013-190378

### SUMMARY

However, when a target having a low reflectivity is detected, in the optical sensor of patent literature 1, the light reception amount of the maximum peak tends to be lower than a target value, and the exposure time tends to become longer. If the exposure time becomes longer, the light reception amount distribution becomes easy to be influenced by an ambient light. As a result, as described above, the light reception amount of the maximum peak is saturated in the light reception amount distribution obtained through the A/D conversion circuit.

Therefore, the present invention aims to provide an optical sensor and a detection method which can suppress the influence of the ambient light and detect a target.

The optical sensor of one aspect of the present invention is an optical sensor which detects a target and includes: a light reception portion, in which multiple pixels respectively receive lights and a light reception distribution signal showing a light reception amount is obtained; an analog-digital conversion portion, which converts the light reception distribution signal to a digital signal for each pixel; an integration portion, which integrates multiple converted light reception distribution signals for each pixel; and a determination portion, which determines the presence or absence of the target based on the integrated light reception distribution signal.

According to the aspect, the light reception amount distribution signal, which shows the light reception amount of each pixel, is obtained, the light reception amount distribution signal is converted to the digital signal for each pixel, and multiple converted light reception distribution signals are integrated for each pixel. Accordingly, in the integrated light reception distribution signal, a difference between a light reception amount of the reflected light of the target and a light reception amount of the ambient light can be sufficiently increased to distinguish a reflected light from the target and the ambient light without increasing the exposure time of each light reception distribution signal. In this way, because it is unnecessary to lengthen the exposure time, the influence of the ambient light can be suppressed to detect the target.

In the above-described aspect, a light projection portion and a difference process portion may be further included, wherein light projection portion emits a light to be projected to the target, and the difference process portion obtains a differential light reception distribution signal between the converted light reception distribution signal during projection and the converted light reception distribution signal during non-projection, and the integration portion integrates multiple differential light reception distribution signals for each pixel.

According to the aspect, ambient light components caused by the ambient light are removed from the light reception distribution signal during projection by obtaining the differential light reception distribution signal between the light reception distribution signal during projection and the light reception distribution signal during non-projection.

In the above-described aspect, a distance calculation portion, which detects a peak in the integrated light reception distribution signal, and calculates a distance from the optical sensor to a location corresponding to the peak, may be further included, and the determination portion determines the presence or absence of the target based on the distance.

According to the aspect, the target can be detected without detecting things beyond a distance to the target, for example a background in a different distance, by detecting the peak in the integrated light reception distribution signal, calculating the distance from the optical sensor to the location corresponding to the peak, and determining the presence or absence of the target based on the distance.

In the above-described aspect, the light reception portion may include an imaging element, in which the multiple pixels are respectively arranged one-dimensionally or two-dimensionally, and the light reception distribution signal obtained by the light reception portion is a light reception amount of each pixel of the imaging element.

According to the aspect, the light reception portion includes the imaging element in which each pixel is arranged one-dimensionally or two-dimensionally, by which the light reception portion, which obtains the light reception amount of each pixel corresponding to the distance from the optical sensor, that is, the light reception distribution signal, can be realized easily.

In addition, a detection method of an optical sensor according to an aspect of the disclosure is a detection method for detecting a target and includes the following steps: multiple pixels respectively receive lights in a light reception portion and the light reception portion obtains a light reception distribution signal showing a light reception amount of each pixel; an analog-digital conversion portion converts the light reception distribution signal to a digital signal for each pixel; an integration portion integrates multiple converted light reception distribution signals for each pixel; and a determination portion determines the presence or absence of the target based on the integrated light reception distribution signal.

According to the aspect, the light reception amount distribution signal which shows the light reception amount of each pixel is obtained, the light reception amount distribution signal is converted to the digital signal for each pixel, and multiple converted light reception distribution signals are integrated for each pixel. Accordingly, in the integrated light reception distribution signal, a difference between a light reception amount of the reflected light of the target and a light reception amount of the ambient light can be sufficiently increased to distinguish a reflected light from the target and the ambient light without increasing the exposure time of each light reception distribution signal. In this way, because it is unnecessary to lengthen the exposure time, the influence of the ambient light can be suppressed to detect the target.

In the above-described aspect, the detection method may further include the following steps: a light projection portion emits a light to be projected to the target; and a difference process portion obtains a differential light reception distribution signal between the converted light reception distribution signal during projection and the converted light reception distribution signal during non-projection; and in the integrating step, the integration portion integrate multiple differential light reception distribution signals for each pixel.

According to the aspect, ambient light components caused by the ambient light are removed from the light reception distribution signal during projection by obtaining the differential light reception distribution signal between the light reception distribution signal during projection and the light reception distribution signal during non-projection.

In the above-described aspect, the detection method may further include the following step: a distance calculation portion detects a peak in the integrated light reception distribution signal, and calculates a distance from the optical sensor to a location corresponding to the peak, and in the determination step, the determination portion determine the presence or absence of the target based on the distance.

According to the aspect, the target can be detected without detecting things beyond a distance to the target, for example a background in a different distance, by detecting the peak in the integrated light reception distribution signal, calculating the distance from the optical sensor to the location corresponding to the peak, and determining the presence or absence of the target based on the distance.

According to the present invention, the optical sensor and the detection method, which can suppress the influence of the ambient light to detect the target, can be provided.

### BRIEF DESCRIPTION OF THE DRAWINGS

FIG. 1 is a diagram which schematically illustrates one example of application cases of an optical sensor of an embodiment.
FIG. 2 is a block diagram which illustrates a configuration of an optical sensor of the embodiment.
FIG. 3 is a schematic diagram which illustrates a detection principle of the optical sensor shown in FIG. 2.
FIG. 4 is a flowchart which illustrates a detection method of an optical sensor.
FIG. 5 is a diagram which illustrates a waveform of a light emitted by a light projection portion.
FIG. 6 is a diagram which illustrates a waveform of a differential light reception distribution signal.
FIG. 7 is a reference diagram which illustrates a waveform of the differential light reception distribution signal which is not integrated.
FIG. 8 is a diagram which illustrates a waveform of an integrated light reception distribution signal.

### DESCRIPTION OF THE EMBODIMENTS

With reference to attached drawings, several embodiments of the disclosure are described. Furthermore, in each diagram, the components donated with the same symbol have the same or similar configuration.

### [Application example]

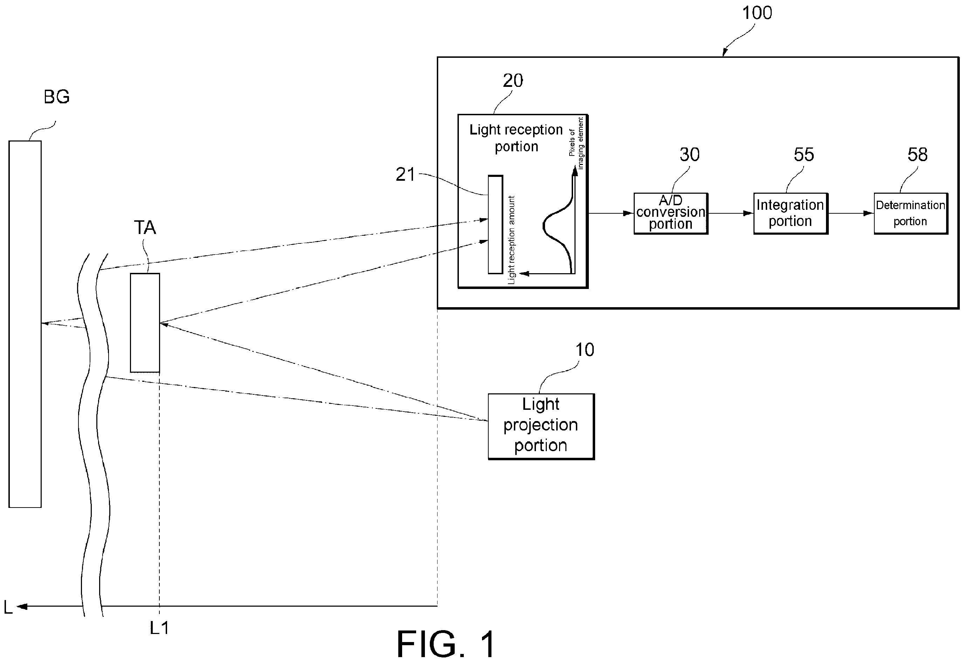

First, one example of cases in which the disclosure is applied is described using FIG. 1. FIG. 1 is a diagram which schematically illustrates one example of application cases of an optical sensor 100 of the embodiment. The optical sensor 100 is a sensor which detects a target TA.

As shown in FIG. 1, the optical sensor 100 includes: a light reception portion 20, in which multiple pixels respectively receive lights and a light reception distribution signal showing a light reception amount of each pixel is obtained; an A/D conversion portion 30, which converts the light reception distribution signal to a digital signal for each pixel; an integration portion 55, which integrates multiple light reception distribution signals for each pixel; and a determination portion 58, which determines the presence or absence of the target TA based on the integrated light reception distribution signal. The light reception distribution signal is an electrical signal of a light reception distribution (referred to as "the light reception distribution signal" hereinafter), which shows the light reception amount of each pixel. The target TA can include anything reflecting lights. The target TA may be, for example, a gloss metal, a white ceramic body, a black gum, a cast and so on. In addition, a surface of the target TA may be uneven, or have a colour different from other parts. Further, the target TA may be moved by a conveyor and so on.

The light reception portion 20 includes, for example, an imaging element 21, in which the multiple pixels are respectively arranged one-dimensionally, that is, in a vertical direction in the example shown in FIG. 1. Each pixel accumulates electrical charges corresponding to the light reception amount of the lights received in a predefined exposure time. Here, the lights received by the light reception portion 20 are incident to different pixels of the imaging element 21 corresponding to a distance L from the optical sensor 100. As one example, a light, which is reflected by what on a distance different from a distance L1 to the target TA, for example, a background BG, is incident to other pixels different from the light reflected by the target TA. In this way, each pixel of the imaging element 21 arranged one-dimensionally is corresponding to the distance L from the optical sensor 100. Besides, each pixel outputs an electrical signal corresponding to the accumulated electrical charges. Accordingly, the light reception portion 20 can obtain the light reception amount of each pixel corresponding to the distance L from the optical sensor 100, which is the light reception distribution signal.

Furthermore, the imaging element 21 is not limited to a configuration in which each pixel is arranged one-dimensionally. Each pixel of the imaging element 21 can also be arranged two-dimensionally.

The A/D conversion portion 30 samples, quantizes, and symbolizes the light reception distribution signal of an analog-signal, and converts the light reception amount to a digital value for each pixel. Besides, the A/D conversion portion 30 outputs the light reception distribution signal converted to a digital signal (referred to as "A/D converted light reception distribution signal" hereinafter). The A/D converted light reception distribution signal is equivalent to one example of the "converted light reception distribution signal" of the disclosure.

As for the light reception distribution signal of each predefined exposure time, the integration portion 55 integrates the light reception amount which becomes the digital value for each pixel for N (N is an integer larger than 2) times. N is called an integration number. Accordingly, in the integrated light reception distribution signal, a peak of a light reception amount sufficient for detecting the target TA can be formed without increasing the exposure time of one time of each light reception distribution signal.

The determination portion 58 detects a location of a maximum peak in the integrated light reception distribution signal, and determines the presence or absence of the target TA based on a relationship between a location of the detected peak and the predetermined distance L1 to the target TA.

Here, conventionally, when the light reception distribution signal is not integrated, in order to distinguish a reflected light from the target TA and an ambient light, it is necessary to lengthen the exposure time and increase the difference between a light reception amount of the reflected light of the target TA and a light reception amount of the ambient light. However, if the exposure time becomes longer, ambient light components of the ambient light also increase, so that an upper limit of an input signal of the A/D conversion portion, namely a saturation voltage, is exceeded near the maximum peak of the light reception distribution signal. Therefore, there is a risk that the maximum peak cannot be accurately detected in the light reception distribution signal.

By contrast, according to the optical sensor 100 of the embodiment, the light reception distribution signal is A/D converted for each pixel and integrated for N times, by which in the integrated light reception distribution signal, the difference between the light reception amount of the reflected light of the target TA and the light reception amount of the ambient light can be sufficiently increased to distinguish the reflected light from the target TA and the ambient light without increasing the exposure time of the light reception distribution signal. In this way, because it is unnecessary to lengthen the exposure time, an influence of the ambient light can be suppressed to detect even the target TA.

### [Configuration example]

### <Optical sensor>

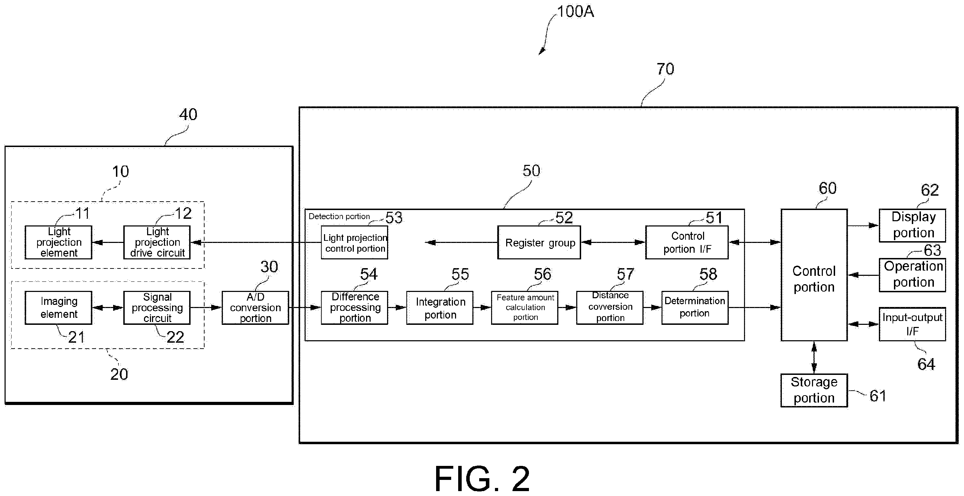

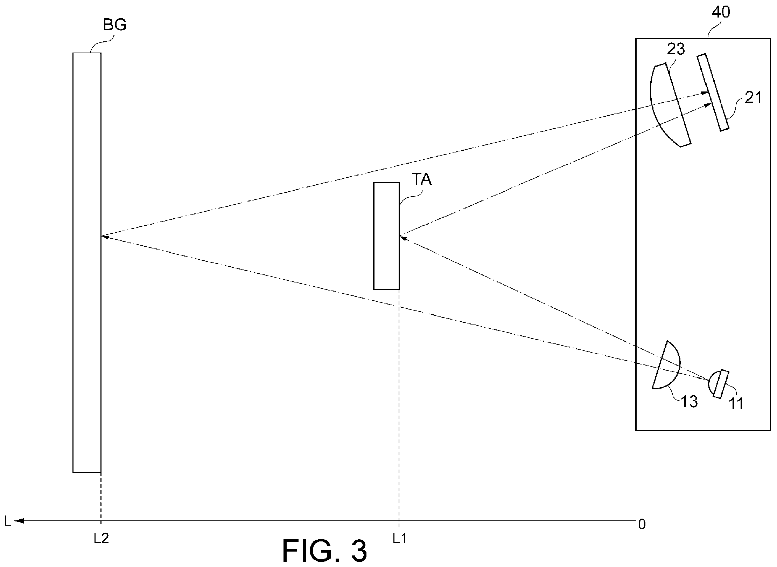

Next, one example of the configuration of the optical sensor of the embodiment is described with reference to FIG. 2 and FIG. 3. FIG. 2 is a block diagram which illustrates the configuration of an optical sensor 100A of the embodiment, and FIG. 3 is a schematic diagram which illustrates a detection principle of the optical sensor 100A shown in FIG. 2.

In an example shown in FIG. 2, the optical sensor 100A of the embodiment includes a light projection portion 10, a light reception portion 20, an A/D (analog-digital) conversion portion 30, a detection portion 50, a control portion 60, a storage portion 61, a display portion 62, an operation portion 63, and an input-output I/F (interface) 64. The light projection portion 10, the light reception portion 20, and the A/D conversion portion 30 are accommodated in a sensor head 40. On the other hand, the detection portion 50, the control portion 60, the storage portion 61, the display portion 62, the operation portion 63, and the input-output I/F 64 are accommodated in a housing 70.

However, an arrangement of each portion of the optical sensor 100A to the sensor head 40 or the housing 70 is not limited to the example shown in FIG. 2. In addition, each portion of the optical sensor 100A is not limited to the configuration accommodated in the sensor head 40 or the housing 70. Each portion of the optical sensor 100A can be divided into more than three parts to be housed, or all the portion of the optical sensor 100A can be accommodated in one housing.

The light projection portion 10 is used for projecting lights to the target TA. The light projection portion 10 includes, for example, a light projection element 11 and a light projection drive circuit 12. The light projection element 11 is a laser diode for example. Elsewise, the light projection element 11 can also be a light-emitting element such as a light-emitting diode and so on. The light projection drive circuit 12 drives the light projection element 11. Specifically, the light projection drive circuit 12 outputs a drive signal to the light projection element 11 based on a control signal input from the detection portion 50. The light projection element 11 is driven by the drive signal and emits lights.

The light reception portion 20 obtains the light reception distribution signal by the multiple pixels respectively receiving the lights. The light reception portion 20 includes, for example, an imaging element 21 and a signal processing circuit 22. The imaging element 21 is a CMOS (Complementary MOSFET) image sensor for example. Elsewise, the imaging element 21 can also be a CCD (Charge-Coupled Device) image sensor. The imaging element 21 includes multiple pixels. Each pixel is arranged one-dimensionally, for example in a predefined straight line. Elsewise, each pixel can also be arranged two-dimensionally. Each pixel accumulates electrical charges corresponding to the light reception amount of the light received in the predefined exposure time. Besides, each pixel outputs an electrical signal corresponding to the accumulated electrical charge.

The signal processing circuit 22 controls a light reception of the imaging element 21. The signal processing circuit 22 outputs the control signal to the imaging element 21 so that, for example, each pixel accumulates the electrical charges in the above-described exposure time, and outputs the electrical signal in a period beyond the exposure time, namely a non-exposure period. In addition, the electrical signal is input from the imaging element 21 to the signal processing circuit 22. The signal processing circuit 22 includes an amplifier circuit (omitted in diagrams), and amplifies the input electrical signal in a predefined gain and outputs the input electrical signal. Furthermore, when the electrical signal of the imaging element 21 is a current signal, the signal processing circuit 22 can also include a current-voltage conversion circuit. On this occasion, the signal processing circuit 22 converts a voltage signal to a voltage value corresponding to the current value in the input current signal. Besides, the signal processing circuit 22 amplifies the converted voltage signal by the amplifier circuit and outputs the converted voltage signal.

Here, one example of a principle by which the optical sensor 100A detects a target is described.

In an example shown in FIG. 3, the sensor head 40 of the optical sensor 100A is arranged separated from the target TA for a predetermined distance L1. A light, which is emitted through a light projection lens 13 from the light projection element 11, is reflected by the target TA. The reflected light is incident to a portion of the pixels of the imaging element 21 through a light reception lens 23. On the other hand, in a location separated from the sensor head 40 for a distance L2 (the distance L2>the distance L1), for example a background BG is arranged. The light reflected by the background BG is incident to other pixels of the imaging element 21 through the light reception lens 23. In this way, each pixel of the imaging element 21, which is arranged one-dimensionally, that is, in the vertical direction in the example of FIG. 3, is corresponding to the distance L from the sensor head 40. In addition, each pixel of the imaging element 21 can also be arranged two-dimensionally, that is, in the vertical direction and a depth direction (a direction perpendicular to the paper surface) in the example shown in FIG. 3. Therefore, by arranging each pixel of the imaging element 21 one-dimensionally or two-dimensionally, the light reception portion 20, which obtains the light reception distribution signal showing the light reception amount corresponding to the distance L from the sensor head 40, can be realized easily.

In the light reception distribution signal, the location of the maximum peak is corresponding to the distance L at which the light reception amount is maximum. Therefore, the target TA apart from the sensor head 40 for the distance L1 can be detected by determining whether the location of the maximum peak of the light reception distribution signal is, for example in a predefined range (±ΔL) from the distance L1 to the target TA.

The exposure time of the imaging element 21 is set to a shorter time compared with a conventional occasion when the light reception distribution signals are not integrated. Specifically, the exposure time of the imaging element 21 is set to such a time that the input signal of the A/D conversion portion 30 is not saturated. For example, while the exposure time is 200 [µs] when the light reception distribution signal is not integrated, the exposure time is set to be 6 [µs], which is less than 1/22, when twenty-two light reception distribution signals are integrated. However, a lower limit of the exposure time depends on a performance of a shutter speed of the light reception portion 20, and is for example about 4 [µs]. In this way, by setting the exposure time of the imaging element 21 to a short time, a response time, which is from the start of light reception of the light reception portion 20 until a detection result is obtained, is almost the same as the time on the occasion when the light reception distribution signals are not integrated.

In the example shown in FIG. 2, the A/D conversion portion 30 converts the light reception distribution signal to the digital signal. Specifically, the A/D conversion portion 30 samples, quantizes, and symbolizes the light reception distribution signal of the analog signal input from the signal processing circuit 22, and converts the light reception amount to the digital value for each pixel. Besides, the A/D conversion portion 30 outputs the light reception distribution signal converted to the digital signal, that is, the A/D converted light reception distribution signal.

The detection portion 50 detects the target TA. The detection portion 50 is configured by, for example, a FPGA (Field-Programmable Gate Array), and a program and data for detecting the target TA are incorporated. The detection portion 50 includes, for example, a control portion I/F (interface) 51, a register group 52, a light projection control portion 53, a difference processing portion 54, the integration portion 55, a feature amount calculation portion 56, a distance conversion portion 57, and the determination portion 58.

Furthermore, the feature amount calculation portion 56 and the distance conversion portion 57 of the embodiment are equivalent to one example of the "distance calculation portion" of the present invention.

The control portion I/F 51 is an interface with the control portion 60 described below. The control portion I/F 51 is configured to exchange data or signals with the control portion 60control portion I/F 51.

The register group 52 is configured by multiple registers. Each register is connected to each portion of the detection portion 50. The register group 52 is configured to hold, for example, calculation results, states, or addresses when accessing memory (omitted in diagrams) and so on of each portion.

The light projection control portion 53 controls the light projection of the light projection portion 10. The light projection control portion 53 outputs the control signal to the light projection portion 10 to control, for example, a projection intensity (power), a projection duration, a projection cycle or a projection interval, and a timing and so on. The control signal is a pulse signal for example. On this occasion, the light projection portion 10 emits a pulse light.

The difference processing portion 54 obtains the differential light reception distribution signal between the light reception distribution signal during projection and the light reception distribution signal during non-projection. In the difference processing portion 54, for example, the A/D converted light reception distribution signal is input from the A/D conversion portion 30. The difference processing portion 54 stores, for example, the A/D converted light reception distribution signal input from the A/D conversion portion 30 during the light projection of the light projection portion 10, in the memory (omitted in diagrams) of the register group 52 or the detection portion 50 for example, as the light reception distribution signal during projection. Similarly, the difference processing portion 54 stores, for example, the A/D converted light reception distribution signal input from the A/D conversion portion 30 when the light projection of the light projection portion 10 is suspended, in the memory of the register group 52 or the detection portion 50, as the light reception distribution signal during non-projection. Besides, when both of the light reception distribution signal during projection and the light reception distribution signal during non-projection are stored, the difference processing portion 54 calculates the differential light reception amount between the light reception distribution signal during projection and the light reception distribution signal during non-projection for each pixel, and obtains the differential light reception distribution signal.

The integration portion 55 is configured to integrate the multiple light reception distribution signals for each pixel. In the integration portion 55, for example, a difference distribution signal is input from the difference processing portion 54. Elsewise, the difference processing portion 54 may be omitted, and the A/D converted light reception distribution signal is input from the A/D conversion portion 30. In the integration portion 55, the light reception distribution signals of the predefined integration number N are input, and the integration portion 55 integrates the light reception amount of each light reception distribution signal for each pixel.

The integration portion 55 is configured so that a processor or a register used for integration has an enough bit length for the voltage value of the light reception distribution signal. Accordingly, when the multiple light reception distribution signals are integrated, a possibility of overflow can be reduced.

The feature amount calculation portion 56 is configured to calculate a feature amount in the integration result. The feature amount is, for example, a coordinate of a centre-of-gravity of the maximum peak. The feature amount calculation portion 56 calculates the coordinate of the centre-of-gravity of the maximum peak in a light reception distribution signal integrated by the integration portion 55. The coordinate is equivalent to a location of an arranged particular pixel.

The distance conversion portion 57 is configured to convert the feature amount to a distance Lc from the sensor head 40. Specifically, the coordinate of the center-of-gravity of the maximum peak calculated by the feature amount calculation portion 56 is converted to the distance Lc to the location corresponding to the coordinate. The distance conversion portion 57 converts the feature amount to the distance Lc from the sensor head 40 to the location corresponding to the center-of-gravity coordinate of the maximum peak by using, for example, a conversion formula or a conversion table which shows a relationship between the coordinate of the light reception distribution signal and the distance L from the sensor head 40.

The determination portion 58 is configured to determine the presence or absence of the target TA based on the light reception distribution signal integrated by the integration portion 55. Specifically, the determination portion 58 determines the presence or absence of the target TA based on whether the distance Lc converted by the distance conversion portion 57 is in the predefined range (±ΔL) from the predetermined distance L1 (L1-ΔL≤Lc≤L1+ΔL). When the distance Lc is in a predefined range (±ΔL) from the distance L1, the determination portion 58 determines that there is a target TA. On the other hand, when the distance Lc is not in the predefined range (±ΔL) from the distance L1, the determination portion 58 determines that there is no target TA. A determination result of the determination portion 58 is output to the control portion 60.

In the above-described example, it is determined whether the distance Lc is in the predefined range (±ΔL) from the distance L1 or not, but it is not limited thereto. It may also be determined whether the distance Lc is equal to the predetermined distance L1 or not. Elsewise, the determination on whether the distance Lc is a predefined range can be determined by only one of a positive value and a negative value (L1-ΔL≤Lc or Lc≤L1+ΔL), or by using values different in positive and negative (L1-ΔL≤Lc≤L1+ΔL2, ΔL1≠ΔL2).

The control portion 60 is configured to control a movement of each portion of the optical sensor 100A. The control portion 60 makes, for example, the detection result input from the detection portion 50 display in the display portion 62. The control portion 60 includes, for example, microprocessors such as a CPU (Central Processing Unit) and so on.

The storage portion 61 is configured to store the program or the data and so on. The storage portion 61 includes, for example, memories such as a ROM (Read Only Memory), a RAM (Random Access Memory), and a buffer memory and so on. In addition, the storage portion 61 can also store a program executed by the control portion 60.

The display portion 62 is configured to output information. The display portion 62 displays, for example, the detection result or a setting content and so on. The display portion 62 includes, for example, a seven-segment display. In addition, the display portion 62 can also include, for example, a display light for informing a warning and so on.

The operation portion 63 is configured to be capable of inputting the information. The operation portion 63 includes, for example, a switch, a button and so on. For example, when an operator (user) operates the operation portion 63, the control portion 60 generates the data corresponding to the operation, whereby the information can be input to the optical sensor 100A.

The input-output I/F 64 is an interface of the optical sensor 100A with an external machine. The input-output I/F 64 is configured to exchange the data and the signals with the external machine.

### [Movement example]

### <Detection method>

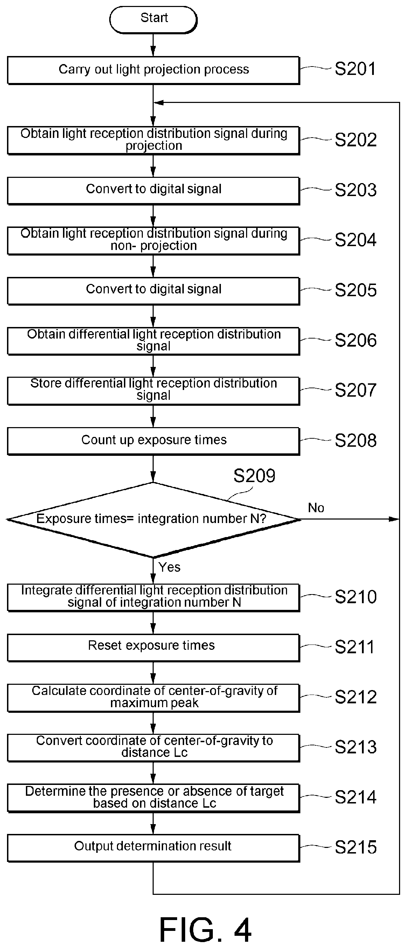

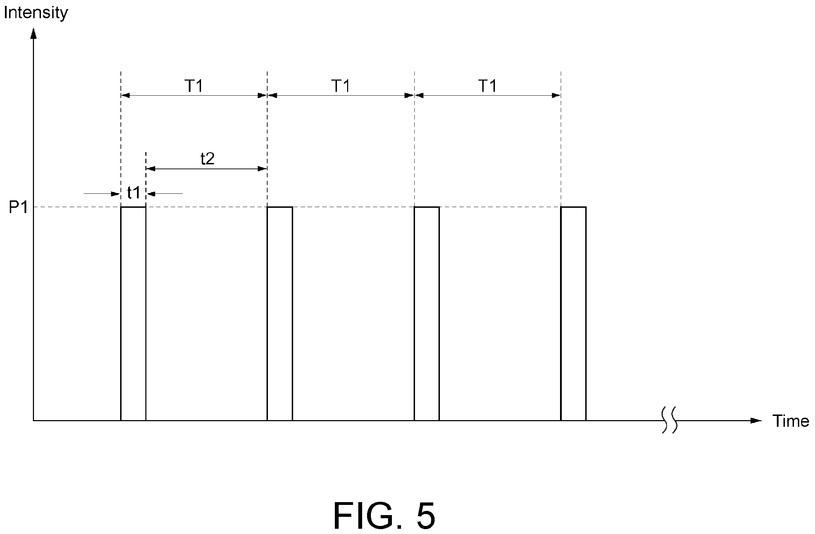

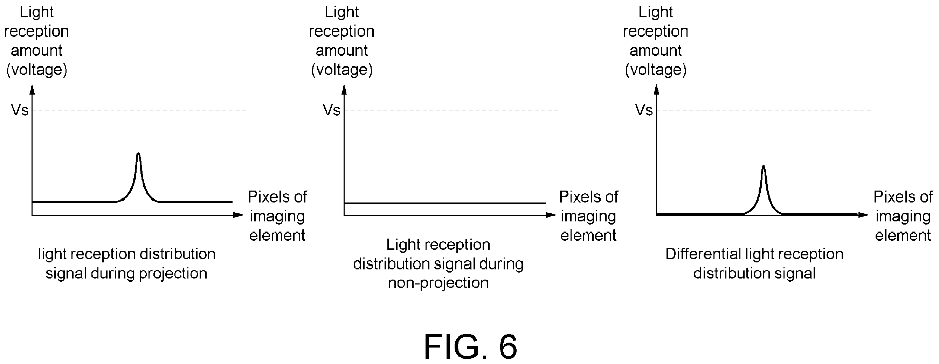

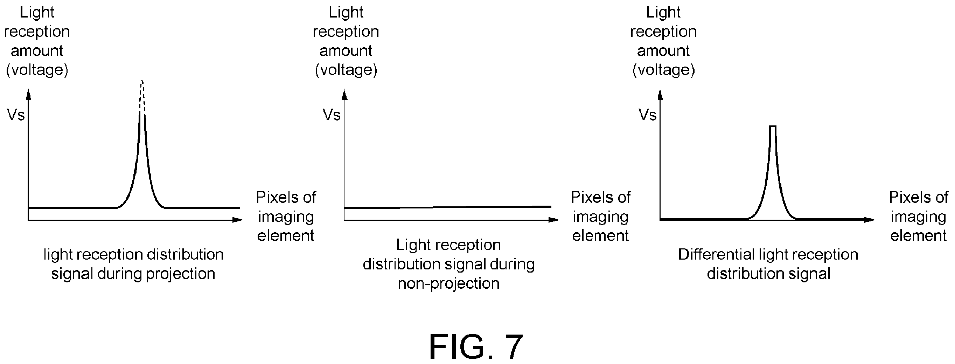

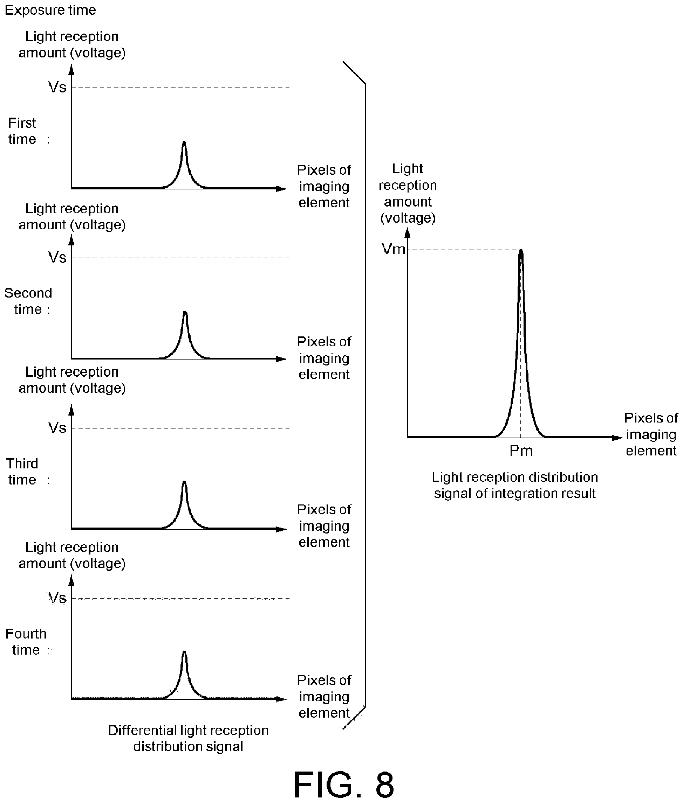

Next, one example of a detection method of the embodiment is described with reference to FIG. 4 to FIG. 8. FIG. 4 is a flowchart which illustrates the detection method of the optical sensor 100A, FIG. 5 is a diagram which illustrates waveforms of lights emitted by the light projection portion 10, FIG. 6 is a diagram which illustrates waveforms of the differential light reception distribution signals, FIG. 7 is a reference diagram which illustrates waveforms of the differential light reception distribution signals which are not integrated, and FIG. 8 is a diagram which illustrates waveforms of the integrated light reception distribution signal.

In an example shown in FIG. 4, first, the light projection portion 10 carries out a light projection process (S201). Specifically, the light projection portion 10 emits the pulse light based on the control signal from the light projection control portion 53.

In an example shown in FIG. 5, the pulse light has a predefined projection intensity P1 and a predefined projection duration (pulse width) t1. In addition, the pulse light is repeatedly output in a predefined projection cycle T1. Here, the projection duration t1 is equivalent to one example of "during projection" of the present invention, and the non-projection duration t2 between one pulse light and another pulse light is equivalent to one example of "during non-projection" of the present invention. In the embodiment, although the projection intensity P1, the projection duration t1, the non-projection duration t2, and the projection cycle T1 are described to have fixed values, each of them can also be changed.

The light projection portion 10 continues to output the pulse light in the projection cycle T1 until the light projection is stopped by the operation of the operation portion 63 for example.

In the example shown in FIG. 4, next, the light reception portion 20 receives the light in the projection duration t1, and obtains the light reception distribution signal during projection (S202). The A/D conversion portion 30 converts the light reception distribution signal during projection obtained in S202 to the digital signal for each pixel (S203).

Then, the light reception portion 20 receives the light in the non-projection duration t2, and obtains the light reception distribution signal during non-projection (S204). The A/D conversion portion 30 converts the light reception distribution signal during non-projection obtained in S204 to the digital signal for each pixel (S205).

Then, the difference processing portion 54 obtains the differential light reception distribution signal between the light reception distribution signal during projection which is A/D converted in S203 and the light reception distribution signal during non-projection which is A/D converted in S205 (S206).

In an example shown in FIG. 6, a waveform shown on the left is the light reception distribution signal during projection, a waveform in the centre is the light reception distribution signal during non-projection, and a waveform shown on the right is the differential light reception distribution signal. A horizontal axis of each waveform is the pixel of the imaging element 21, and a vertical axis is the voltage showing the light reception amount. Here, there are other lights except the light of the light projection, namely the ambient light, in an environment where the sensor head 40 is arranged. When incident to the imaging element 21, the ambient light increases the voltage value of all the light reception distribution signals as the ambient light components in the light reception distribution signal. The ambient light is similarly incident to the imaging element 21 in both of the projection duration and the non-projection duration, so that the light reception portion 20 can obtain the light reception distribution signal of the ambient light in the non-projection duration. Therefore, the difference processing portion 54 obtains the differential light reception distribution signal between the light reception distribution signal during projection and the light reception distribution signal during non-projection, by which the ambient light components are removed from the light reception distribution signal during projection.

Here, one example of the differential light reception distribution signal, which is not integrated conventionally, is described for reference.

In an example shown in FIG. 7, a waveform shown on the left is the light reception distribution signal during projection, a waveform in the centre is the light reception distribution signal during non-projection, and a waveform shown on the right is the differential light reception distribution signal. A horizontal axis of each waveform is the pixel of the imaging element, and a vertical axis is the voltage showing the light reception amount. When the light reception distribution signals are not integrated, in order to distinguish the reflected light from the target TA and the ambient light, it is necessary to lengthen the exposure time and increase the difference between the light reception amount of the reflected light of the target TA and the light reception amount of the ambient light. Particularly, when a reflectivity of the target TA is low, the difference between the light reception amount of the reflected light of the target TA and the light reception amount of the ambient light is reduced, so that the exposure time tends to become longer.

However, if the exposure time becomes longer, the ambient light components of the ambient light also increase, so that the upper limit of the input signal of the A/D conversion portion 30, that is, the saturation voltage Vs, is exceeded near the maximum peak of the light reception distribution signal during projection. Therefore, there is a risk that the maximum peak in the differential light reception distribution signal cannot be accurately detected.

By contrast, in an example of FIG. 8, for example when four difference distribution signals are integrated, the exposure time in each light reception distribution signal shown on the left is 1/4 of the exposure time of the example shown in FIG. 7. As a result, the voltage of each light reception distribution signal, namely the light reception amount becomes near 1/4. Therefore, different from the occasion shown in the example of FIG. 7 when the light reception distribution signals are not integrated, each light reception distribution signal does not exceeds the saturation voltage Vs of the A/D conversion portion 30.

In the example shown in FIG. 4, next, the integration portion 55 stores the difference distribution signal obtained in S206 in the memory of the register group 52 or the detection portion 50 (S207). Besides, the integration portion 55 counts up an exposure times by using the memory of the register group 52 or the detection portion 50 (S208). An initial value of the exposure times is set to "zero" for example. Elsewise, the integration portion 55 can also count down the exposure times. On this occasion, the initial value of the exposure times is set to the above-described integration number N.

Then, the integration portion 55 determines whether the exposure times reaches the predefined integration number N (S209).

When a determination result of S209 is that the exposure times does not reach the predefined integration number N, each step from S202 to S208 is repeated.

On the other hand, when the determination result of S209 is that the exposure times reaches the predefined integration number N, the integration portion 55 stores the differential light reception distribution signal of the integration number N. Therefore, the integration portion 55 reads out N differential light reception distribution signals from the memory of the register group 52 or the detection portion 50, and integrates the light reception amount of the differential light reception distribution signal of the integration number N for each pixel (S210). After integration, the integration portion 55 resets the exposure times (S211). The reset exposure times returns to the above-described initial value.

In the example shown in FIG. 8, the waveform shown on the left is four differential light reception distribution signals, and the waveform shown on the right is the light reception distribution signal of the integration result. The four differential light reception distribution signals are respectively exposed from the first time to the fourth time. A horizontal axis of each waveform is the pixel of the imaging element 21, and a vertical axis is the voltage showing the light reception amount. Voltages of the four differential light reception distribution signals in the example shown in FIG. 8 are about 1/4 of the differential light reception distribution signal in the example shown in FIG. 7. By integrating these four differential light reception distribution signals for each pixel, in the integrated light reception distribution signal, the difference between the light reception amount of the reflected light of the target TA and the light reception amount of the ambient light can be sufficiently increased to distinguish the reflected light from the target TA and the ambient light without increasing the exposure time of each light reception distribution signal. In this way, because it is unnecessary to lengthen the exposure time, the influence of the ambient light can be suppressed to detect the target TA.

In addition, by converting the light reception distribution signal to the digital signal for each pixel, in the light reception distribution signal which is obtained by integrating multiple A/D converted light reception distribution signals for each pixel, an S/N ratio (Signal-to-Noise Ratio) can be increased. Theoretically, in the light reception distribution signal which is obtained by integrating N A/D converted light reception distribution signals for each pixel, a random noise can be reduced to 1/√N, and a dynamic range can be increased to N times.

Then, the feature amount calculation portion 56 calculates the coordinate of the centre-of-gravity of the maximum peak in the light reception distribution signal integrated by S210 (S212). The feature amount calculation portion 56 calculates, for example, the coordinate of the pixel Pm which is the light reception amount Vm in the example shown in FIG. 8. Then, the distance conversion portion 57 converts the coordinate of the center-of-gravity calculated in S212 to the distance Lc from the sensor head 40 (S213).

Then, the determination portion 58 determines the presence or absence of the target TA based on the distance Lc converted in S213 (S214). For example, when the distance Lc is in the predefined range (±ΔL) from the predetermined distance L1, the determination portion 58 determines that there is a target TA. On the other hand, when the distance Lc is not in the predefined range (±ΔL) from the predetermined distance L1, the determination portion 58 determines that there is no target TA. Besides, the determination portion 58 outputs the determination result to the control portion 60 (S215). In this way, the target TA can be detected without detecting things beyond the distance L1 to the target, for example the background BG in the different distance L2, by detecting the peak in the integrated light reception distribution signal, calculating the distance Lc from the sensor head 40 to the location corresponding to the peak, and determining the presence or absence of the target TA based on the distance Lc.

After a step of S215, the optical sensor 100A repeats each step from S202 to S215 until the detection of the target TA is stopped by the operation of the operation portion 63 for example.

In the embodiment, although the differential light reception distribution signals of the integration number N are stored, and N differential light reception distribution signals are integrated by summing the N light reception distribution signals for each pixel, it is not limited thereto. The differential light reception distribution signals of the integration number N can also be integrated for each pixel by sequentially adding the light reception amount for each pixel every time the differential light reception distribution signal is obtained.

As described above, in the embodiment, the light reception amount distribution signal which shows the light reception amount of each pixel is obtained, the light reception amount distribution signal is converted to the digital signal for each pixel, and A/D converted light reception distribution signals of the integration number N are integrated for each pixel. Accordingly, in the integrated light reception distribution signal, the difference between the light reception amount of the reflected light of the target TA and the light reception amount of the ambient light can be sufficiently increased to distinguish the reflected light from the target TA and the ambient light without increasing the exposure time of each light reception distribution signal. In this way, because it is unnecessary to lengthen the exposure time, the influence of the ambient light can be suppressed to detect even the target TA.

### (Appendix)

1. A optical sensor 100A, which detects a target TA, including:
   a light reception portion 20, in which multiple pixels respectively receive lights and a light reception distribution signal showing a light reception amount of each pixel is obtained;
   an A/D conversion portion 30, which converts the light reception distribution signal to a digital signal for each pixel;
   an integration portion 55, which integrates multiple A/D converted light reception distribution signals for each pixel; and
   a determination portion 58, which determines the presence or absence of a target TA based on the integrated light reception distribution signal.
5. A detection method, which detects a target TA, including the following steps:
   multiple pixels respectively receive lights in a light reception portion and the light reception portion 20 obtains a light reception distribution signal showing a light reception amount of each pixel;
   an A/D conversion portion 30 converts the light reception distribution signal to a digital signal for each pixel;
   an integration portion 55 integrates multiple A/D converted light reception distribution signals for each pixel; and
   a determination portion 58 determines the presence or absence of the target TA based on the integrated light reception distribution signal.

### [Description of the Symbols]

- 10: Light projection portion
- 11: Light projection element
- 12: Light projection drive circuit
- 13: Light projection lens
- 20: Light reception portion
- 21: Imaging element
- 22: Signal processing circuit
- 23: Light reception lens
- 30: A/D conversion portion
- 40: Sensor head
- 50: Detection portion
- 51: Control portion I/F
- 52: Register group
- 53: Light projection control portion
- 54: Difference processing portion
- 55: Integration portion
- 56: Feature amount calculation portion
- 57: Distance conversion portion
- 58: Determination portion
- 60: Control portion
- 61: Storage portion
- 62: Display portion
- 63: Operation portion
- 64: Input-output I/F
- 70: Housing
- 100, 100A: Optical sensor
- BG: Background
- L, L1, L2, Lc: Distance
- N: Integration number
- P1: Projection intensity
- t1: Projection duration (pulse width)
- t1: Projection duration
- t2: Non-projection duration
- T1: Projection cycle
- TA: Target
- Vs: Saturation voltage

## Claims

1. An optical sensor (100), **characterized in that** the optical sensor (100) detects a target (TA), the optical sensor (100) comprises:
a light reception portion (20), in which multiple pixels respectively receive lights and a light reception distribution signal showing a light reception amount of each pixel is obtained;
an analog-digital conversion portion (30), which converts the light reception distribution signal to a digital signal for each pixel;
an integration portion (55), which integrates multiple converted light reception distribution signals for each pixel; and
a determination portion (58), which determines the presence or absence of the target (TA) based on the integrated light reception distribution signal.

2. The optical sensor (100) according to claim 1, further comprising:
a light projection portion (10), which emits a light to be projected to the target (TA); and
a difference processing portion (54), which obtains a differential light reception distribution signal between the converted light reception distribution signal during projection and the converted light reception distribution signal during non-projection, wherein
the integration portion (55) integrates multiple differential light reception distribution signals for each pixel.

3. The optical sensor (100) according to claim 1 or 2, further comprising:
a distance calculation portion (57), which detects a peak in the integrated light reception distribution signal, and calculates a distance from the optical sensor (100) to a location corresponding to the peak, wherein
the determination portion (58) determines the presence or absence of the target (TA) based on the distance.

4. The optical sensor (100) according to any one of claims 1 to 3, wherein
the light reception portion (20) comprises an imaging element (21), in which the multiple pixels are respectively arranged one-dimensionally or two-dimensionally, and
the light reception distribution signal obtained by the light reception portion (20) is a light reception amount of each pixel of the imaging element (21).

5. A detection method, **characterized in that** is a detection method of an optical sensor (100) detecting a target (TA), the detection method comprises the following steps:
multiple pixels respectively receive lights in a light reception portion (20) and the light reception portion (20) obtains a light reception distribution signal showing a light reception amount of each pixel;
an analog-digital conversion portion (30) converts the light reception distribution signal to a digital signal for each pixel;
an integration portion (55) integrates multiple converted light reception distribution signals for each pixel; and
a determination portion (58) determines the presence or absence of the target (TA) based on the integrated light reception distribution signal.

6. The detection method according to claim 5, further comprising the following steps:
a light projection portion (10) emits a light to be projected to the target (TA); and
a difference processing portion (54) obtains a differential light reception distribution signal between the converted light reception distribution signal during projection and the converted light reception distribution signal during non-projection, wherein
in the integrating step, the integration portion (55) integrates multiple differential light reception distribution signals for each pixel.

7. The detection method according to claim 5 or 6, further comprising the following step:
a distance calculation portion (57) detects a peak in the integrated light reception distribution signal, and calculates a distance from the optical sensor (100) to a location corresponding to the peak, wherein
in the determining step, the determination portion (58) determines the presence or absence of the target (TA) based on the distance.
